(19) Europäisches Patentamt / European Patent Office / Office européen des brevets

(11) **EP 2 628 893 B1**

(12) **FASCICULE DE BREVET EUROPEEN**

(45) Date de publication et mention
de la délivrance du brevet:
**19.08.2020 Bulletin 2020/34**

(51) Int Cl.:
***E21B 41/00*** *(2006.01)*

(21) Numéro de dépôt: **13290018.4**

(22) Date de dépôt: **23.01.2013**

(54) **Procédé d'exploitation d'un gisement à partir d'une technique de sélection des positions de puits à former**

Ausbeutungsverfahren eines Erdöllagers mit Hilfe einer Auswahltechnik der Stellen für Bohrlöcher

Method for exploiting a deposit using a technique for selecting the positions of drilling wells

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **16.02.2012 FR 1200461**

(43) Date de publication de la demande:
**21.08.2013 Bulletin 2013/34**

(73) Titulaire: **IFP Energies nouvelles
92500 Rueil-Malmaison (FR)**

(72) Inventeur: **Le Ravalec, Mickaele
92500 Rueil-Malmaison (FR)**

(74) Mandataire: **IFP Energies nouvelles
Département Propriété Industrielle
Rond Point de l'échangeur de Solaize
BP3
69360 Solaize (FR)**

(56) Documents cités:
  EP-A1- 2 270 548    EP-A1- 2 426 630
  WO-A2-01/23829    US-A- 5 101 898

• VARGAS-GUZMAN J ET AL: "Integration of 3D-seismic impedance into High-resolution Geocellular Models using Non-collocated Downscaling", SPE RESERVOIR CHARACTERIZATION AND SIMULATION CONFERENCE AND EXHIBITION, SPE, US, no. SPE 148363, 9 octobre 2011 (2011-10-09), pages 1-10, XP007921324,
• CAVALCANTE J S DE A: "Methodology for Quality Map Generation to Assist with the Selection and Refinement of Production Strategies", SPE INTERNATIONAL OIL AND GAS CONFERENCE AND EXHIBITION, XX, XX, no. SPE 101940-STU, 9 octobre 2005 (2005-10-09), pages 1-10, XP002676803,
• REN W ET AL: "Quantifying Resources for the Surmont Lease With 2D Mapping and Multivariate Statistics", SPE RESERVOIR EVALUATION AND ENGINEERING, SPE, US, 1 avril 2008 (2008-04-01), pages 1-11, XP007921323,

**EP 2 628 893 B1**

**Description**

La présente invention concerne le domaine technique de l'industrie pétrolière, et plus particulièrement l'exploitation de réservoirs souterrains, tels que des réservoirs pétroliers ou des sites de stockage de gaz.

En particulier, l'invention permet de planifier efficacement le développement d'un réservoir en sélectionnant les positions où forer de nouveaux puits, pour lesquelles le potentiel de production sera maximal.

L'optimisation et l'exploitation des gisements pétroliers reposent sur une description aussi précise que possible de la structure, des propriétés pétrophysiques, des propriétés des fluides, etc., du gisement étudié. Pour ce faire, les spécialistes utilisent un outil qui permet de rendre compte de ces aspects de façon approchée : le modèle de réservoir. Un tel modèle constitue une maquette du sous-sol, représentative à la fois de sa structure et de son comportement. Généralement, ce type de maquette est représenté sur un ordinateur, et l'on parle alors de modèle numérique. Un modèle de réservoir comporte un maillage ou grille, généralement tridimensionnelle, associée à une ou plusieurs cartes de propriétés pétrophysiques (porosité, perméabilité, saturation,...). L'association consiste à attribuer des valeurs de ces propriétés pétrophysiques à chacune des mailles de la grille.

Pour être jugé fiable, le modèle de réservoir doit vérifier autant que possible l'ensemble des données collectées sur le terrain : les données de diagraphie mesurées le long des puits, les mesures réalisées sur des échantillons de roche prélevés dans les puits, les données déduites de campagnes d'acquisition sismiques, les données de production comme les débits d'huile, d'eau, de pression,... Ces données sont insuffisantes pour caractériser précisément les valeurs des propriétés pétrophysiques à attribuer aux mailles du modèle. C'est pourquoi on recourt d'ordinaire à un formalisme stochastique. Les propriétés pétrophysiques sont considérées comme des réalisations de fonctions aléatoires. On génère alors une image possible du réservoir, c'est-à-dire un modèle, à partir de techniques géostatistiques de simulation. La résolution des équations d'écoulement pour ce modèle fournit des réponses en production. Ces réponses sont alors comparées aux données de production mesurées dans les puits. Pour accroître la prédictivité du modèle de réservoir, il faut minimiser l'écart entre les réponses simulées et les données acquises sur le terrain. Cette étape passe par un processus de calage ou d'optimisation. Ce dernier est en général très coûteux en temps calcul, car il est itératif et nécessite une simulation d'écoulement par itération. Or, une unique simulation d'écoulement implique souvent quelques heures de temps calcul. De plus, il n'existe pas un seul modèle de réservoir respectant les données de production, mais plusieurs du fait de l'incertitude sur les paramètres. L'un des facteurs prépondérants au niveau des incertitudes concerne la distribution spatiale des propriétés pétrophysiques : on parle alors d'incertitude géologique.

Lorsqu'un modèle respectant les données mesurées sur le terrain est obtenu, il est utilisé pour prédire les déplacements de fluide dans le réservoir et planifier le développement futur du champ. Par exemple, pour les champs matures, il faut pouvoir sélectionner les zones où forer de nouveaux puits, soit pour produire l'huile par déplétion, soit pour injecter un fluide qui maintient la pression à un niveau suffisant dans le réservoir. Pour apprécier la performance d'un puits en un point, on peut s'appuyer sur le modèle de réservoir, y positionner le puits à la position souhaitée et exécuter une simulation d'écoulement. La performance d'un puits s'apprécie à partir de la quantité d'hydrocarbure qu'il permet de produire. L'objectif final étant de maximiser la production ou la rentabilité du champ, il faudrait pouvoir tester toutes les positions possibles et ainsi sélectionner la meilleure d'entre elles. Une telle approche est inappropriée en pratique, car trop consommatrice en temps de calcul. Une alternative consiste à lancer un processus d'optimisation visant à placer un puits le mieux possible pour optimiser la production. Toutefois, cette démarche reste délicate à mettre en œuvre, car elle nécessite quelques milliers d'itérations.

Le concept de carte d'indicateurs de production, également appelée dans la littérature carte de qualité, a été introduit pour répondre de façon pratique au problème du placement des nouveaux puits dans un réservoir. Il s'agit d'une carte bidimensionnelle, comprenant un ensemble de mailles, où chaque maille est associée à une valeur réelle qui montre comment un nouveau puits placé dans la maille en question impacte la production ou la valeur actuelle nette (VAN) par rapport au cas de base. Le cas de base correspond au schéma d'exploitation initial, c'est-à-dire ici un schéma pour lequel aucun nouveau puits n'est ajouté. (Da Cruz, P.S., Horne, R.N., Deutsch, C., The Quality map: A tool for reservoir quantification and decision making, SPE ATCE, SPE 56578, Houston, TX, USA, 1999).

Le document WO 01/23829 A2 décrit un procédé pour déterminer les positions optimales d'un puits pour un modèle de réservoir 3D utilisant une carte de qualité. Pour cette carte de qualité, des valeurs de qualités sont déterminées au moyen de la valeur maximale de la qualité pour la colonne du maillage 3D correspondant à la maille. En chaque maille du volume 3D, la valeur de la qualité est déterminée par addition de valeurs au sein d'un volume de drainage.

Un indicateur de production définit un impact sur la production du fluide (hydrocarbure) lié à l'ajout d'un puits dans la maille considérée. Pour construire cette carte, on peut faire une simulation d'écoulement pour chaque maille où il est possible de placer un puits. Si le réservoir comprend NX et NY mailles suivant les axes X et Y, le nombre total de mailles à examiner est de NX×NY auquel on soustrait les nombres de mailles non actives et de mailles dans lesquelles on a déjà un puits pour le cas de base. Cette approche nécessite un temps de calcul significatif dès que NX×NY est important.

Pour réduire les temps de calcul, une approche par interpolation a été envisagée (Cottini-Loureiro, A., Araujo, M., Optimized well location by combination of multiple realization approach and quality map methods, SPE 95413, SPE ATCE, Dallas, TX, US, 9-12 October, 2005). On fait alors une simulation pour certaines mailles de la carte, les valeurs dans les autres mailles sont estimées par interpolation.

Par ailleurs, l'incertitude géologique étant importante, il faut étudier non pas un, mais plusieurs modèles de réservoir respectant les données collectées sur le champ et construire une carte d'indicateurs de production pour chacun de ces modèles de réservoir. Les techniques d'interpolation utilisées à ce jour pour construire ces cartes sont essentiellement basées sur un krigeage (Chilès, J.P., Delfiner, P., Geostatistics: Modeling Spatial Uncertainty. Wiley, New York, 695 pp, 1999) et demandent plusieurs simulations d'écoulement. Si ces dernières doivent être réalisées pour chaque modèle de réservoir, le nombre total de simulations d'écoulement est important.

Ainsi, l'objet de l'invention concerne un procédé alternatif pour exploiter un gisement pétrolier à partir d'un modèle de réservoir. Ce procédé alternatif repose sur la construction de la carte d'indicateurs de production à partir de l'intégration d'informations suivant différents niveaux de résolution : un premier niveau dit "approché" pour lequel on approxime les indicateurs de production par des simulations d'écoulement rapides et un deuxième niveau dit "précis" pour lequel on détermine des indicateurs de production par des simulations d'écoulement précises. Par conséquent, grâce à cette méthode, on construit une carte précise d'indicateurs de production en réduisant significativement les appels au simulateur d'écoulement complexe et donc en réduisant les temps de calcul.

## Le procédé selon l'invention

L'invention concerne un procédé d'exploitation d'un réservoir souterrain, notamment d'un réservoir pétrolier, traversé par au moins un premier puits à partir duquel un fluide est produit, dans lequel on détermine une position d'au moins un second puits à forer à l'aide d'une carte d'indicateurs de production comprenant un ensemble de mailles, chaque maille étant associée à un indicateur de production (IP) définissant un impact sur la production du fluide d'un ajout d'un puits dans cette maille. Le procédé comprend les étapes suivantes :

- on construit ladite carte au moyen des étapes suivantes :

    a) on détermine des indicateurs de production (IP) sur un premier groupe de mailles de ladite carte, au moyen d'une simulation d'écoulement précise sur une période de temps définie, à l'aide d'un simulateur d'écoulement et d'un modèle de réservoir ;
    b) on détermine des indicateurs de production (IP) sur un second groupe de mailles de ladite carte, au moyen d'une simulation d'écoulement approchée pour laquelle on modifie par rapport à ladite simulation d'écoulement précise au moins : la période de temps définie, le simulateur d'écoulement ou le modèle de réservoir, la modification de la période de temps définie consiste en une réduction de ladite période de temps, la modification du simulateur d'écoulement consiste à simplifier ledit simulateur d'écoulement en négligeant certains phénomènes physiques lors de l'écoulement du fluide et la modification du modèle de réservoir consiste à diminuer la résolution dudit modèle de réservoir;
    c) on interpole lesdits indicateurs de production (IP) sur l'ensemble des mailles de ladite carte, au moyen d'un modèle d'interpolation contraint par lesdits indicateurs de production (IP) ; et

- on définit la position dudit second puits par la maille où ledit indicateur de production est maximal.

Selon une variante de l'invention, l'indicateur de production (IP) mesure une variation de paramètres impactant la production du fluide lors d'un ajout d'un puits dans la maille.

De préférence, l'indicateur de production (IP) est un incrément de volume de fluide produit en plaçant un puits dans la maille ou une variation de la valeur nette attendue.

Avantageusement, les mailles des premier et second groupes sont sélectionnées par échantillonnage.

Selon un mode de réalisation, on modifie à la fois le modèle de réservoir et le simulateur d'écoulement.

De manière avantageuse, le modèle d'interpolation est construit par une méthode de cokrigeage des indicateurs de production (IP).

En variante, on répète les étapes a) à c) pour différents modèles de réservoir, puis on détermine une carte d'indicateurs de production (IP) correspondant à la moyenne des indicateurs de production (IP) calculés en chaque maille pour lesdits différents modèles de réservoir et une carte de variance des indicateurs de production (IP), on définit alors la position dudit second puits par la maille vérifiant un critère relatif à la maximisation de la moyenne et une minimisation de la variance des indicateurs de production.

L'invention concerne en outre un produit programme d'ordinateur téléchargeable depuis un réseau de communication et/ou enregistré sur un support lisible par ordinateur et/ou exécutable par un processeur, dans lequel il comprend des instructions de code de programme pour la mise en œuvre du procédé selon l'invention, lorsque ledit programme est exécuté sur un ordinateur.

Selon une variante de l'invention, on réalise un forage d'exploration à ladite position déterminée par le procédé.

## Présentation succincte des figures

D'autres caractéristiques et avantages du procédé selon l'invention, apparaîtront à la lecture de la description ci-après d'exemples non limitatifs de réalisations, en se référant aux figures annexées et décrites ci-après.

La figure 1 illustre une carte d'indicateurs de production de référence.

La figure 2 illustre une carte d'indicateurs de production obtenue par intégration des indicateurs de production "précis".

La figure 3 illustre une carte d'indicateurs de production obtenue par intégration des indicateurs de production "approchés".

La figure 4 illustre une carte d'indicateurs de production obtenue par le procédé selon l'invention.

La figure 5 représente l'évolution du volume total d'huile produit en fonction du temps pour différents modèles de réservoir.

La figure 6 illustre une carte d'indicateurs de production obtenue par le procédé selon l'invention par moyenne des cartes d'indicateurs de production calculées pour différents modèles de réservoir.

La figure 7 illustre une carte de variance des indicateurs de production obtenue par le procédé selon l'invention pour différents modèles de réservoir.

## Description détaillée du procédé

L'invention concerne un procédé d'exploitation d'un réservoir souterrain, notamment d'un réservoir pétrolier, traversé par au moins un premier puits à partir duquel un fluide est produit, dans lequel on détermine une position d'au moins un second puits à forer à l'aide d'une carte d'indicateurs de production comprenant un ensemble de mailles, chaque maille étant associée à un indicateur de production (IP) définissant un impact sur la production du fluide d'un ajout d'un puits dans cette maille. Le procédé comprend les étapes suivantes :

1) construction de la carte au moyen des étapes suivantes :

a) détermination des indicateurs de productions précis ;
b) détermination des indicateurs de production approchés ;
c) interpolation ; et

2) définition de la position du second puits.

### Etape 1) Construction de la carte d'indicateurs de production

Une carte d'indicateurs de production comprend un ensemble de mailles, chaque maille étant associée à un indicateur de production (IP). Un indicateur de production (IP) quantifie un impact sur la production du fluide dû à l'ajout d'un puits dans cette maille. L'indicateur de production (IP) mesure une variation des paramètres impactant la production du fluide lors d'un ajout d'un puits dans la maille. Cet indicateur de production (IP) peut être notamment une variation de production totale de l'ensemble des puits, une variation de la valeur actuelle nette attendue, une variation de la pression ou du débit. Selon un mode de réalisation, l'indicateur de production (IP) est l'incrément de volume d'huile produit en plaçant un puits, par exemple un puits injecteur, dans cette maille.

Selon l'invention, la carte d'indicateurs de production est construite à partir de valeurs d'indicateurs de production calculés précisément pour le modèle de réservoir considéré et de valeurs d'indicateurs de production approchés pour certaines mailles préalablement sélectionnées. Les valeurs de ces indicateurs de production sont ensuite interpolées sur l'ensemble des mailles de la carte. Les étapes a) et b) décrites ci-dessous sont indépendantes et peuvent être réalisées dans l'ordre exposé ci-dessous, dans l'ordre inverse ou simultanément.

### a) Détermination d'une première série d'indicateurs de production

Dans un premier temps, on sélectionne un premier groupe de mailles.

Avantageusement, on sélectionne des mailles de la carte à estimer à partir d'une technique d'échantillonnage, qui peut être entièrement informatisée, ou informatisée, puis complétée manuellement, ou réalisée entièrement manuellement. Par exemple, ladite technique d'échantillonnage peut être un hypercube latin, s'appuyant sur un critère "Maximin", qui permet de découper l'espace en sous-espaces équiprobables et échantillonnés de manière uniforme. Les mailles représentent les positions pour lesquelles on veut évaluer l'impact sur la production. La méthode d'échantillonnage par hypercube latin présente l'avantage d'aboutir à une répartition des mailles sélectionnées couvrant raisonnablement le modèle de réservoir. Toutefois, le spécialiste peut estimer qu'une zone de la carte est prometteuse en termes de positionnement de puits et dans ce cas échantillonner plus précisément la zone en question, pour obtenir des indicateurs de production plus précis dans cette zone.

Dans un second temps, on détermine de manière précise les indicateurs de production (il s'agit d'indicateurs de production "précis") en ces mailles du premier groupe. On détermine pour chaque maille sélectionnée l'indicateur de production (IP), par une simulation d'écoulement "précise".

De manière préférentielle, on exécute une simulation d'écoulement pour chaque maille sélectionnée du premier groupe, en partant de l'hypothèse qu'on rajoute un puits dans la maille sélectionnée. Pour exécuter une simulation d'écoulement, il est connu du spécialiste d'utiliser un logiciel appelé simulateur d'écoulement tel que Pumaflow ® (IFP Energies nouvelles, France). De manière préférentielle, on exécute une simulation d'écoulement de fluide contenu dans le réservoir vers les puits producteurs, pour chaque maille sélectionnée, en partant de l'hypothèse qu'on rajoute un puits dans ladite maille sélectionnée. Ces simulations demandent un temps de calcul très important : elles sont faites à partir d'un simulateur d'écoulement précis, c'est-à-dire un simulateur d'écoulements prenant en compte tous les phénomènes physiques lors de l'écoulement du fluide, notamment les changements de phase, les effets PVT. Un logiciel tel que PumaFlow ® correspond à cette définition, car il décrit la physique des écoulements le mieux possible. De manière générale, il s'agit du simulateur d'intérêt à partir duquel on souhaite établir la carte précise d'indicateurs de production ; il est choisi pour rendre compte de la physique des écoulements de manière optimale. Pour déterminer ces indicateurs de production "précis", la simulation est appliquée au modèle de réservoir, pour lequel on veut établir la carte d'indicateurs de production. Ce modèle est dit précis car il correspond précisément au modèle de réservoir examiné. En outre, cette simulation est réalisée sur une période de temps définie, l'objectif étant d'apprécier l'impact d'un nouveau puits sur la production à un temps t donné.

Par conséquent, si à l'étape de sélection du premier groupe, Np mailles sont retenues, on exécute Np simulations d'écoulement avec pour chacune d'entre elles un unique puits ajouté dans la maille considérée. Ces simulations donnent la valeur précise, ou "fine", de l'indicateur de production (IPp1, IPp2 ... IPpNp) pour les mailles sélectionnées.

*b) Détermination d'une seconde sérié d'indicateurs de production*

Dans un premier temps, on sélectionne un second groupe de mailles. Ces mailles correspondent aux mailles de la grille sur laquelle est défini le modèle de réservoir étudié.

Avantageusement, on sélectionne des mailles de la carte à estimer à partir d'une technique d'échantillonnage, qui peut être entièrement informatisée, ou informatisée, puis complétée manuellement, ou réalisée entièrement manuellement. Par exemple, ladite technique d'échantillonnage est un hypercube latin, s'appuyant sur un critère "Maximin", qui permet de découper l'espace en sous-espaces équiprobables et échantillonnés de manière uniforme. Les mailles représentent les positions pour lesquelles on veut évaluer l'impact sur la production. La méthode d'échantillonnage par hypercube latin présente l'avantage d'obtenir une répartition des mailles sélectionnées acceptables. Toutefois, le spécialiste peut estimer qu'une zone de la carte est prometteuse en termes de positionnement de puits et dans ce cas échantillonner plus précisément la zone en question, pour enrichir l'estimation des indicateurs de production dans cette zone. On notera que selon l'invention, les deux groupes de mailles n'ont pas besoin d'être disjoints ; certaines mailles peuvent appartenir aux deux groupes. Les étapes a) et b) peuvent donc être réalisées indépendamment l'une de l'autre.

Dans un second temps, on détermine les indicateurs de production (il s'agit d'indicateurs de production "approchés") en ces mailles du deuxième groupe. On détermine pour chaque maille sélectionnée l'indicateur de production (IP), par une simulation d'écoulement rapide (ou "approchée").

Selon un mode de réalisation préférentiel, on exécute une simulation d'écoulement de fluide contenu dans le réservoir vers les puits producteurs, pour chaque maille sélectionnée, en partant de l'hypothèse qu'on rajoute un puits dans ladite maille sélectionnée. La rapidité de la détermination des indicateurs de production est selon l'invention obtenue en modifiant au moins une des conditions de simulation suivantes : réduction de la période de temps simulée, diminution de la résolution du modèle de réservoir, ou de la précision du simulateur d'écoulement.

Selon une première variante de ce mode de réalisation, approximer les indicateurs de production (dits indicateurs de production "approchés") peut consister à simuler les écoulements au moyen du simulateur d'écoulement précis utilisé à l'étape précédente, appliqué au modèle de réservoir utilisé à l'étape précédente, mais sur une période de temps plus réduite que celle normalement considérée pour apprécier l'impact d'un nouveau puits sur la production.

En variante, on peut faire des simulations d'écoulement pour le modèle de réservoir étudié au moyen d'un simulateur d'écoulement simplifié au lieu du simulateur d'écoulement utilisé à l'étape précédente. On appelle simulateur d'écoulement simplifié, un simulateur d'écoulement, utilisant des équations mathématiques simplifiées de la physique mise en œuvre. Ces équations simplifiées sont obtenues notamment en négligeant certains phénomènes physiques, par exemple les pressions capillaires dans le réservoir. On parle alors de physique réduite. On pourra par exemple utiliser un simulateur par lignes de courant. Le simulateur d'écoulement simplifié est donc une version simplifiée du simulateur d'écoulement utilisé à l'étape a) : il permet de représenter approximativement les écoulements de fluide dans le réservoir.

Une autre possibilité est de faire des simulations d'écoulement au moyen du simulateur d'écoulement utilisé à l'étape précédente appliqué à un modèle de réservoir de résolution inférieure au modèle de réservoir principal, c'est-à-dire un modèle dont les mailles sont de dimensions plus grandes que les mailles du modèle de réservoir étudié. Dans ce cas, les mailles du second groupe sont transposées dans un maillage de résolution inférieure par correspondance entre les deux grilles lors de la mise à l'échelle. Alternativement, les mailles du second groupe peuvent être choisies directement parmi les mailles d'une grille dite "approchée" superposée à la carte initiale. Ce modèle de réservoir correspond à une représentation basse résolution du modèle de réservoir précis ; il est en général construit à partir de techniques de mise à l'échelle.

Il est aussi possible de faire des simulations d'écoulement appliqué au modèle de réservoir de basse résolution à partir du simulateur d'écoulement simplifié.

L'avantage est le gain en temps de calcul par rapport aux simulations à lancer pour estimer la valeur exacte (ou précise) de l'indicateur de production.

Ainsi, selon ce premier mode de réalisation préférentiel, on fait une simulation d'écoulement pour chaque maille sélectionnée et on en déduit l'indicateur de production ("approché" ou "grossier") associé. Si à l'étape de sélection, Na mailles sont retenues dans le deuxième groupe, on exécute Na simulations d'écoulement avec pour chacune d'entre elles un unique puits ajouté à la position considérée. Ces simulations donnent une valeur approchée, dite grossière, de l'indicateur de production (IPa1, IPa2 ... IPaNa) pour les mailles sélectionnées. Ces simulations requièrent un temps de calcul bien plus réduit de sorte que l'information au niveau grossier correspond à un réseau plus dense.

*c) Interpolation*

Afin de ne pas avoir à déterminer les indicateurs de production sur l'ensemble des mailles de la carte à partir d'un processus coûteux en temps de calcul comme une simulation d'écoulement, et par conséquent pour diminuer le temps de calcul, l'indicateur de production est estimé à partir d'un modèle d'interpolation sur l'ensemble des mailles non échantillonnées de la carte. L'interpolation se base sur un modèle d'interpolation contraint par les indicateurs précis et approchés déterminés aux étapes précédentes.

De préférence, le modèle d'interpolation est un métamodèle multi-fidélité, dont la construction s'appuie sur le concept de cokrigeage qui est une extension naturelle du krigeage. L'idée de base de l'approche multi-fidélité est de contraindre le métamodèle par plusieurs niveaux de résolution d'information. Pour simplifier les notations, on se limite au cas de deux niveaux : les indicateurs de production déterminés à l'étape b) (approchés) et les indicateurs de production déterminés à l'étape a) (précis). Les premiers permettent d'esquisser des tendances dans les variations des indicateurs de production. Les seconds en donnent des valeurs exactes pour des positions données.

Les deux niveaux d'information sont utilisés pour construire la carte d'indicateurs de production à partir d'un co-krigeage (Chilès, J.P., Delfiner, P., Geostatistics: Modeling Spatial Uncertainty. Wiley, New York, 695 pp, 1999) avec ajustement des paramètres du modèle d'interpolation.

L'idée de base est d'utiliser un modèle auto-régressif de la forme suivante :

$$IPp(\mathbf{x}) = \rho IPa(\mathbf{x}) + \delta p(\mathbf{x}) \text{ et } IPa(\mathbf{x}) = \delta a(\mathbf{x})$$

$\rho$ est un facteur d'échelle entre le modèle à l'échelle précise et le modèle à l'échelle approchée ; il est déterminé de manière connue du spécialiste lorsqu'on utilise un modèle de réservoir approché pour déterminer les indicateurs de production approchés. IPp et IPa sont respectivement les modèles d'interpolation aux échelles précise et approchée. $\delta p(\mathbf{x})$ représente la correction entre le modèle à l'échelle précise et le modèle à l'échelle approchée. On notera IP1, IP2, IPN, les indicateurs de production précis (p) ou approchés (a) aux mailles sélectionnées.

On construit d'abord un modèle d'interpolation des indicateurs de production approchés, déterminés à l'étape b), qui détermine en chaque maille de la carte, un indicateur de production à partir des indicateurs de production approchés connus. Pour ce faire, on utilise un processus Gaussien (ou krigeage) :

$$IPa(\mathbf{x}) = f(x, y, D\min, IPa1, IPa2, ...IPaNa)$$

Les mailles sont caractérisées par un ensemble de régresseurs regroupés dans le vecteur x. Cet ensemble comprend au moins les coordonnées spatiales x et *y* des mailles et optionnellement également la distance Dmin entre la maille à interpoler et le puits le plus proche de ladite maille à interpoler. Ce dernier régresseur peut être introduit pour prendre en compte les interférences entre les puits. Les paramètres du modèle d'interpolation sont déterminés en maximisant la fonction de vraisemblance associée.

De la même façon, on met en place un modèle de processus Gaussien (krigeage) pour le terme de correction $\delta p(\mathbf{x})$ :

$$\delta p(\mathbf{x}) = f(x, y, D\min, IPp1, IPp2, ...IPpNp, \rho)$$

Les paramètres de ce modèle sont également déterminés en maximisant la fonction de vraisemblance associée.
Ayant défini des processus Gaussiens pour modéliser $IPa$ et $\delta p$, on est capable d'exprimer les indicateurs de production $IPp$ en chaque maille à l'échelle précise à l'aide du modèle suivant :

$$IPp(\mathbf{x}) = f(x, y, D\min, IPa1, IPa2, ...IPpNp, IPp1, IPp2, ...IPpNp, \rho)$$

Le modèle d'interpolation étant connu, on détermine par interpolation les indicateurs de production précis aux mailles non sélectionnées de la carte. L'estimation des indicateurs de production précis par interpolation permet de s'affranchir d'un simulateur annexe et de réduire les temps de calcul.

Etape 2) Définition de la position du second puits

La valeur maximale de l'indicateur de production ainsi construit correspond à la maille où il sera le plus avantageux de positionner un puits. On ajoute au schéma de production alors un puits qu'on intègre au groupe des puits existants. Le puits pourra alors être foré ultérieurement.
Lorsqu'on dispose de différents modèles de réservoir respectant les données déjà collectées on peut répéter les étapes de construction de la carte d'indicateurs de production pour chaque modèle de réservoir. Cette approche est rendue possible grâce à la prise en compte de l'information approchée dans le métamodèle. En effet, l'ajout de cette information permet de réduire les besoins en information précise et donc de limiter les appels, en général coûteux en temps de calcul, au simulateur d'écoulement précis. Pour chaque modèle de réservoir, on répète les étapes a) à c) et on obtient alors au final un ensemble de cartes d'indicateurs de production précis qui diffèrent entre elles du fait de l'incertitude géologique. On détermine alors la moyenne et la variance de ces cartes d'indicateurs de production précis, ce qui donne au final une carte montrant la moyenne des indicateurs de production et une carte en montrant la variance. Grâce à l'invention, il est donc possible de construire des cartes d'indicateur de production pour plusieurs modèles de réservoir, ainsi on peut tenir compte des incertitudes de construction des modèles de réservoir.
On ajoute alors au schéma de production un puits en tenant compte à la fois du gain en production (carte moyenne) et du risque associé (carte de variance). Le puits pourra alors être foré ultérieurement.

**Exemple d'application**

Pour illustrer le procédé, on reprend un cas test élaboré dans le cadre du projet européen "Production forecasting with UNcertainty Quantification" (PUNQ) à partir d'un réservoir pétrolier réel. Le champ contient de l'huile et du gaz. Il est produit à partir de 6 puits producteurs localisés près de la ligne de contact entre l'huile et le gaz. Le schéma de production de base couvre la période allant du 01/01/1967 au 15/01/1975. Lors de la première année sont réalisés de nombreux essais de puits. Les puits sont ensuite fermés pendant trois ans avant d'être mis en production à débit imposé les quatre dernières années.
Au terme de ces huit années se pose la question d'ajouter un puits d'injection d'eau pour soutenir la pression dans le réservoir. On suppose que du 15/01/75 au 15/01/80, la production est pilotée par les six puits producteurs et un puits injecteur. Le problème consiste à identifier la maille la plus stratégique pour l'implantation du puits injecteur.
Il s'agit alors de construire, en utilisant le procédé selon l'invention, une carte d'indicateurs de production précis (IPp), et d'en déduire la position du puits.
Le modèle de réservoir est discrétisé sur une grille de 19×28×5 mailles, dont 1761 sont actives. Cette configuration nous amène à construire une carte d'indicateurs de production précis sur une grille de 19x28 mailles, dont 396 peuvent accueillir un nouveau puits. Le cas de base correspond au volume d'huile cumulé produit par les six puits producteurs au 15/01/80 en l'absence de tout puits injecteur. L'indicateur de production précis attribué à une maille de la carte d'indicateurs de production précise correspond à la quantité d'huile produite en plus lorsqu'un puits injecteur est placé dans la maille en question.

L'objectif étant *in fine* de réduire autant que possible les appels au simulateur d'écoulement précis, on prend en compte un niveau d'information "approché" qui vient compléter le niveau d'information "précis". Le niveau d'information approché est déterminé à partir de simulations d'écoulement faites pour le modèle de réservoir étudié, mais sur une période de temps restreinte. Au lieu de calculer l'indicateur de production pour une injection d'eau entre janvier 1975 et janvier 1980, on simule une injection entre janvier 1975 et janvier 1976. Les simulations ainsi réalisées donnent accès à des valeurs d'indicateurs de production approchés.

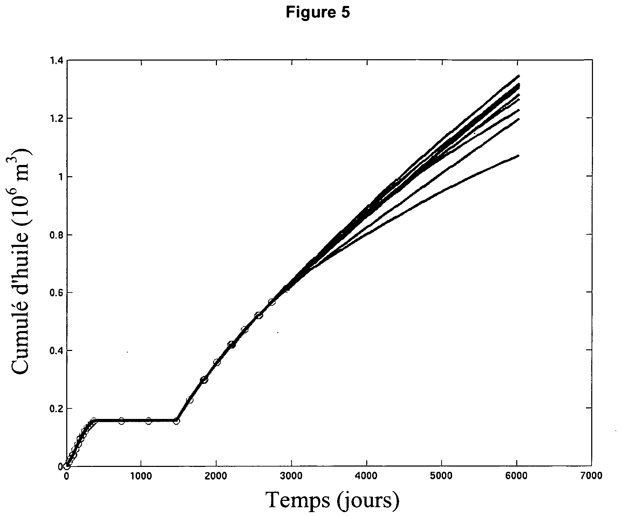

La première étape consiste à construire plusieurs modèles de réservoir respectant les données de production collectées durant 1967 et 1975, ce qui se fait par une approche classique de calage d'historique. On obtient ainsi dix modèles de base qui nous permettent d'appréhender l'incertitude géologique liée à la distribution spatiale des hétérogénéités dans le réservoir. Ces dix modèles respectent les données de production mesurées, comme par exemple le volume total d'huile produit. Par contre, au delà de 1975, leurs comportements diffèrent du fait de l'incertitude géologique. La figure 5 illustre le volume total d'huile produit en fonction du temps pour dix modèles de réservoir. Ces dix modèles respectent les données mesurées pendant les huit premières années (cercles). Au delà, leurs comportements diffèrent.

On cherche à présent à construire une carte d'indicateurs de production précis pour chacun des modèles considérés. Pour réduire les temps de calcul, on construit ces cartes en intégrant une information au niveau précis et une information complémentaire au niveau approché. Ce faisant, on diminue le nombre de mailles pour lesquelles on calcule les indicateurs de production précis, et donc le temps de calcul pour déterminer l'information au niveau précis.

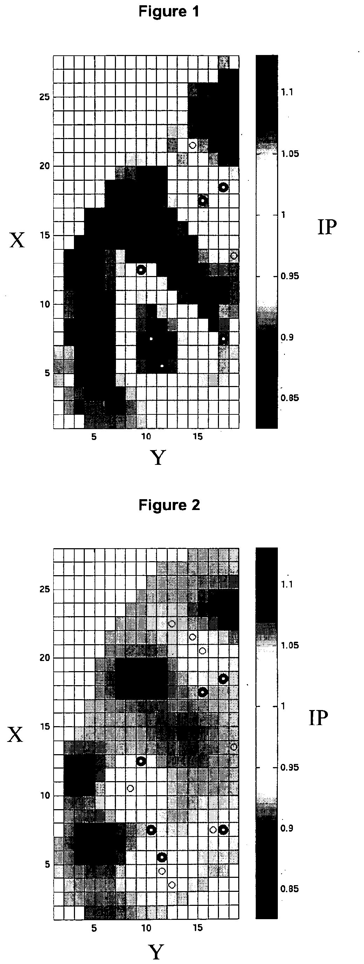

A titre d'exemple, on se concentre sur le premier modèle de réservoir. Il est à noter qu'une simulation d'écoulement pour le cas PUNQ demande un temps de calcul très réduit. Dans ces conditions très particulières, il est tout à fait envisageable de faire une simulation d'écoulement pour toutes les mailles possibles, ce qui donne accès à la carte exacte d'indicateurs de production fin. Cette carte exacte d'indicateurs de production est illustrée en figure 1, sur laquelle les cercles noirs épais indiquent la position des puits producteurs existants.

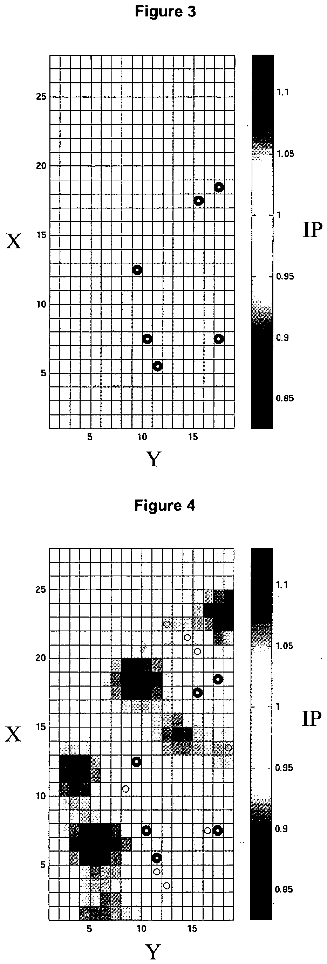

On considère à présent que l'information approchée correspond à une carte d'indicateurs de production approchés obtenus à partir d'une simulation d'écoulement restreinte à la période 1975-1976. L'information précise, quant à elle, est donnée par des indicateurs de production précis calculés exactement pour quinze positions possibles, tirées au hasard, pour le puits injecteur. La carte d'indicateurs de production approchés pour le premier modèle de réservoir est représentée sur la figure 3. Son calcul demande un temps négligeable car la période de simulation est réduite.

De son côté, les indicateurs de production sont évalués précisément en quinze mailles, ce qui implique quinze simulations d'écoulement sur la période de temps complète 1975-1980. A titre de comparaison, on construit la carte d'indicateurs de production précis, en tenant compte de l'information précises seulement, cette carte est illustrée en figure 2 (pour le premier modèle de réservoir). Pour ces figures 2 et 3, les cercles noirs fins représentent les quinze positions pour lesquelles sont calculés les indicateurs de producteurs (précis ou approchés).

On construit selon le procédé de l'invention la carte d'indicateurs de production pour le premier modèle de réservoir, celle-ci est illustrée à la figure 4. On vérifie que la carte d'indicateurs de production construite à partir d'un métamodèle multi-fidélité intégrant les deux niveaux d'information est beaucoup plus proche de la carte d'indicateurs de référence. Pour parvenir à un résultat analogue avec uniquement de l'information précise (figure 3), on peut montrer qu'il faut environ deux fois plus de simulations (une trentaine) d'écoulement sur la période de temps complète, ce qui demande un temps de calcul important.

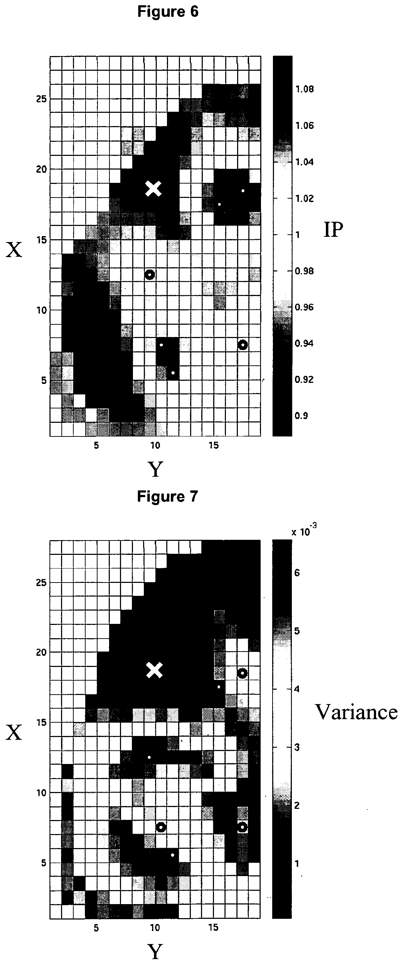

Le gain en temps de calcul lié à la mise en place d'un métamodèle multi-fidélité nous permet d'envisager la construction de la carte d'indicateurs pour chacun des dix modèles de réservoir. On en déduit alors des cartes montrant la moyenne (figure 6) et la variance (figure 7) des indicateurs de production. Ces deux cartes permettent de sélectionner la position du nouveau puits injecteur tout en connaissant le risque associé, ce risque étant lié à l'incertitude géologique. Par exemple, le spécialiste pourra préconiser de placer le nouveau puits injecteur au point indiqué par la croix car il est associé à un gain significatif en production et à un risque réduit.

## Revendications

**1.** Procédé d'exploitation d'un réservoir souterrain, notamment d'un réservoir pétrolier, traversé par au moins un premier puits à partir duquel un fluide est produit, dans lequel on détermine une position d'au moins un second puits à forer à l'aide d'une carte d'indicateurs de production, ladite carte comprenant un ensemble de mailles, chaque maille étant associée à un indicateur de production (IP) définissant un impact sur la production du fluide d'un ajout d'un puits dans cette maille, **caractérisé en ce qu'**il comprend les étapes suivantes :

    - on construit ladite carte au moyen des étapes suivantes :

        a) on détermine des indicateurs de production (IP) sur un premier groupe de mailles de ladite carte, au moyen d'une simulation d'écoulement précise sur une période de temps définie, à l'aide d'un simulateur d'écoulement et d'un modèle de réservoir ;

b) on détermine des indicateurs de production (IP) sur un second groupe de mailles de ladite carte, au moyen d'une simulation d'écoulement approchée pour laquelle on modifie par rapport à ladite simulation d'écoulement précise au moins : la période de temps définie, le simulateur d'écoulement ou le modèle de réservoir, la modification de la période de temps définie consiste en une réduction de ladite période de temps, la modification du simulateur d'écoulement consiste à simplifier ledit simulateur d'écoulement en négligeant certains phénomènes physiques lors de l'écoulement du fluide et la modification du modèle de réservoir consiste à diminuer la résolution dudit modèle de réservoir ;

c) on interpole lesdits indicateurs de production (IP) sur l'ensemble des mailles de ladite carte, au moyen d'un modèle d'interpolation contraint par lesdits indicateurs de production (IP) ; et

- on définit la position dudit second puits par la maille où ledit indicateur de production est maximal.

2. Procédé selon la revendication 1, dans lequel l'indicateur de production (IP) mesure une variation de paramètres impactant la production du fluide lors d'un ajout d'un puits dans la maille.

3. Procédé selon l'une des revendications précédentes, dans lequel l'indicateur de production (IP) est un incrément de volume de fluide produit en plaçant un puits dans la maille ou une variation de la valeur nette attendue.

4. Procédé selon l'une des revendications précédentes, dans lequel les mailles des premier et second groupes sont sélectionnées par échantillonnage.

5. Procédé selon l'une des revendications précédentes, dans lequel on modifie à la fois le modèle de réservoir et le simulateur d'écoulement.

6. Procédé selon l'une des revendications précédentes, dans lequel le modèle d'interpolation est construit par une méthode de cokrigeage des indicateurs de production (IP).

7. Procédé selon l'une des revendications précédentes, dans lequel on répète les étapes a) à c) pour différents modèles de réservoir, puis on détermine une carte d'indicateurs de production (IP) correspondant à la moyenne des indicateurs de production (IP) calculés en chaque maille pour lesdits différents modèles de réservoir et une carte de variance des indicateurs de production (IP), on définit alors la position dudit second puits par la maille vérifiant un critère relatif à la maximisation de la moyenne et une minimisation de la variance des indicateurs de production.

8. Produit programme d'ordinateur téléchargeable depuis un réseau de communication et/ou enregistré sur un support lisible par ordinateur et/ou exécutable par un processeur, dans lequel il comprend des instructions de code de programme pour la mise en œuvre du procédé selon l'une quelconque des revendications précédentes, lorsque ledit programme est exécuté sur un ordinateur.

9. Procédé selon l'une quelconque des revendications 1 à 7, dans lequel on réalise un forage d'exploration à ladite position déterminée.


**Patentansprüche**

1. Verfahren zur Erschließung eines unterirdischen Lagers, insbesondere eines Erdöllagers, das von mindestens einem ersten Bohrloch durchdrungen wird, aus dem ein Fluid produziert wird, bei dem eine Position mindestens eines zweiten zu bohrenden Bohrlochs mithilfe einer Karte mit Produktionskennzahlen bestimmt wird, wobei die Karte eine Anordnung aus Maschen umfasst, wobei jede Masche einer Produktionskennzahl (IP) zugeordnet ist, welche die Auswirkungen eines Hinzufügens eines Bohrlochs in dieser Masche auf die Produktion des Fluids definiert, **dadurch gekennzeichnet, dass** es die folgenden Schritte umfasst:

- die Karte wird mittels der folgenden Schritte erstellt:

a) Produktionskennzahlen (IP) werden für eine erste Maschengruppe der Karte mittels einer präzisen Strömungssimulation über einen festgelegten Zeitraum mithilfe eines Strömungssimulators und eines Lagermodells bestimmt;

b) Produktionskennzahlen (IP) werden für eine zweite Maschengruppe der Karte mittels einer näherungsweisen Strömungssimulation bestimmt, bei der in Bezug auf die präzise Strömungssimulation mindestens geändert wird: der festgelegte Zeitraum, der Strömungssimulator oder das Lagermodell, wobei die Änderung des festgelegten Zeitraums in einer Verkürzung des Zeitraums besteht, die Änderung des Strömungssimulators in einer Vereinfachung des Strömungssimulators unter Vernachlässigung bestimmter physikalischer Phänomene beim Strömen des Fluids besteht und die Änderung des Lagermodells in einer Verringerung der Auflösung des Lagermodells besteht;

c) die Produktionskennzahlen (IP) werden mittels eines durch die Produktionskennzahlen (IP) eingeschränkten Interpolationsmodells über alle Maschen der Karte interpoliert; und

- die Position des zweiten Bohrlochs wird durch die Masche festgelegt, in der die Produktionskennzahl am größten ist.

2. Verfahren nach Anspruch 1, bei dem die Produktionskennzahl (IP) eine Variation von Parametern misst, die sich auf die Produktion des Fluids bei einer Hinzufügung eines Bohrlochs in der Masche auswirken.

3. Verfahren nach einem der vorhergehenden Ansprüche, bei dem die Produktionskennzahl (IP) ein Fluidvolumeninkrement ist, das beim Anordnen eines Bohrlochs in der Masche produziert wird, oder eine Variation des erwarteten Nettowerts.

4. Verfahren nach einem der vorhergehenden Ansprüche, bei dem die Maschen der ersten und zweiten Gruppe stichprobenartig ausgewählt werden.

5. Verfahren nach einem der vorhergehenden Ansprüche, bei dem sowohl das Lagermodell als auch der Strömungssimulator geändert werden.

6. Verfahren nach einem der vorhergehenden Ansprüche, bei dem das Interpolationsmodell mit einer Methode des Co-Krigens der Produktionskennzahlen (IP) erstellt wird.

7. Verfahren nach einem der vorhergehenden Ansprüche, bei dem die Schritte a) bis c) für verschiedene Lagermodelle wiederholt werden, daraufhin eine Karte mit Produktionskennzahlen (IP), die dem Mittelwert der in jeder Masche für die verschiedenen Lagermodelle berechneten Produktionskennzahlen (IP) entsprechen, und eine Varianzkarte der Produktionskennzahlen (IP) bestimmt werden und dann die Position des zweiten Bohrlochs durch die Masche festgelegt wird, die ein Kriterium bezüglich der Maximierung des Mittelwerts und einer Minimierung der Varianz der Produktionskennzahlen erfüllt.

8. Computerprogrammprodukt, das von einem Kommunikationsnetzwerk herunterladbar ist und/oder auf einem computerlesbaren Datenträger gespeichert ist und/oder von einem Mikroprozessor ausführbar ist, wobei es Programmcodeanweisungen umfasst, die bei der Ausführung des Programms auf einem Computer das Verfahren nach einem der vorhergehenden Ansprüche ausführen.

9. Verfahren nach einem der Ansprüche 1 bis 7, bei dem eine Explorationsbohrung an der bestimmten Position ausgeführt wird.

## Claims

1. Method for exploiting an underground reservoir, in particular a petroleum reservoir, passed through by at least one first well from which a fluid is produced, wherein a position of at least one second well to be drilled is determined using a map of production indicators, said map comprising a set of cells, each cell being associated with a production indicator (IP) defining an impact on the production of the fluid of an addition of a well in this cell, **characterized in that** it comprises the following steps:

- said map is constructed by means of the following steps:

a) production indicators (IP) are determined for a first group of cells of said map, by means of a precise flow simulation over a defined period of time, using a flow simulator and a reservoir model;

b) production indicators (IP) are determined for a second group of cells of said map, by means of an approximate flow simulation for which at least the following are modified with respect to said precise flow simulation: the defined period of time, the flow simulator or the reservoir model, the modification of the defined time period consisting in a decrease in said period of time, the modification of the flow simulator consisting in simplifying said flow simulator by neglecting certain physical effects during the flow of the fluid and the modification of the reservoir model consisting in decreasing the resolution of said reservoir model; c) said production indicators (IP) are interpolated for all of the cells of said map, by means of an interpolation model constrained by said production indicators (IP); and

- the position of said second well is defined by the cell in which said production indicator is maximal.

2. Method according to Claim 1, wherein the production indicator (IP) measures a variation in parameters impacting the production of the fluid during the addition of a well to the cell.

3. Method according to one of the preceding claims, wherein the production indicator (IP) is an increment of volume of fluid produced by placing a well in the cell or a variation in the expected net value.

4. Method according to one of the preceding claims, wherein the cells of the first and second groups are selected by sampling.

5. Method according to one of the preceding claims, wherein both the reservoir model and the flow simulator are modified.

6. Method according to one of the preceding claims, wherein the interpolation model is constructed by co-kriging the production indicators (IP).

7. Method according to one of the preceding claims, wherein steps a) to c) are repeated for various reservoir models, then a map of production indicators (IP) corresponding to the mean of the production indicators (IP) computed in each cell for said various reservoir models and a map of the variance of the production indicators (IP) are determined, the position of said second well then being defined by the cell meeting a criterion relating to the maximization of the mean and a minimization of the variance of the production indicators.

8. Computer-program product downloadable from a communication network and/or stored on a medium that is readable by computer and/or executable by a processor, wherein it comprises program-code instructions for implementing the method according to any one of the preceding claims, when said program is executed on a computer.

9. Method according to any one of Claims 1 to 7, wherein exploratory drilling is carried out in said determined position.

## Figure 1

## Figure 2

## Figure 3

## Figure 4

**Figure 5**

**Figure 6**

**Figure 7**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 0123829 A2

**Littérature non-brevet citée dans la description**

- **DA CRUZ, P.S. ; HORNE, R.N. ; DEUTSCH, C.** *The Quality map: A tool for reservoir quantification and decision making,* 1999
- **COTTINI-LOUREIRO, A. ; ARAUJO, M.** *Optimized well location by combination of multiple realization approach and quality map methods,* 09 Octobre 2005
- **CHILÈS, J.P. ; DELFINER, P.** Geostatistics: Modeling Spatial Uncertainty. Wiley, 1999, 695